# EUROPÄISCHE PATENTSCHRIFT

(11) **EP 0 512 082 B1**
(45) Veröffentlichungstag und Bekanntmachung des Hinweises auf die Patenterteilung: **09.02.2000**
(21) Anmeldenummer: 91918974.6
(22) Anmeldetag: 11.11.1991
(51) Int. Cl.: H01J 37/32, C23C 14/32

(54) **SCHALTUNGSANORDNUNG ZUR STROMVERSORGUNG FÜR GEPULST BETRIEBENE VAKUUMBÖGEN**
POWER-SUPPLY CIRCUIT FOR PULSE-OPERATED VACUUM-ARC DEVICES
CIRCUIT POUR L'ALIMENTATION EN COURANT D'ARCS A VIDE EN REGIME PULSE

(30) Priorität: 22.11.1990 DE 4037388
(43) Veröffentlichungstag der Anmeldung: 11.11.1992
(73) Patentinhaber: FRAUNHOFER-GESELLSCHAFT ZUR FÖRDERUNG DER ANGEWANDTEN FORSCHUNG E.V., 80636 München (DE)
(72) Erfinder: Siemroth, Peter, Dr., O-8060 Dresden (DE); Scheibe, Hans-Joachim, Dr., O-8021 Dresden (DE); Uhlemann, Hans-Jörg, Dr., O-8060 Dresden (DE)
(86) Internationale Anmeldenummer: DE9100870
(87) Internationale Veröffentlichungsnummer: WO9209999

(56) Entgegenhaltungen:
- WO-A-89/06708
- DD-A- 280 338
- DE-A- 3 427 520
- FR-A- 2 505 601

## Beschreibung

Die Erfindung bezieht sich auf eine Schaltungsanordnung zur Stromversorgung von gepulst betriebenen Vakuumbögen, wie sie z.B. als Plasmaquelle in der Beschichtungstechnik und zur massenspektroskopischen Untersuchung von leitfähigen Proben genutzt werden.

Bogenentladungen im Vakuum werden als Plasmaquellen für Beschichtungszwecke breit angewendet. Für eine Reihe von Anwendungen hat sich die Verwendung gepulster Bogenentladungen bewährt, bzw. wird eine solche vorgeschlagen. Darunter gibt es solche Anwendungen, bei denen die Absicht besteht, kurzzeitig sehr hohe Beschichtungsraten zu erreichen, um verhältnismäßig dicke Schichten auf begrenzter Fläche mit einer einzigen Entladung abzuscheiden. Solche Anordnungen sind von Boxmann (R. L. Boxmann, S. Goldsmith, 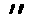 Fast deposition of metallurgical coatings vacuum arc", Thin Solid Films, Bd. 139 (1986) S. 41-52) und Maslov (A.I. Maslov, G.K. Dmitriev, Yu.D. Chistyakov, 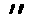 Impulsnyi istochnik uglerodnoj plazmy dlya tekhnologicheskikh tselej", Pribory i tekhnika eksperimenta, Heft 3, 1985, S. 146-149) beschrieben worden.

Andererseits wurden gepulste Bgenentladungen definierter kurzer Dauer mit relativ hoher Folgefrequenz (größer 100 Hz) vogeschlagen, um bei jeder Entladung nur eine genau definierte Umgebung des Zündorts zu verdampfen. Dabei können die Einzelentladungen sowohl fokussierter Laserbestrahlung (DD 277 178 A3) als auch durch Triggerentladungen (7) (DD 280 338 A1) gezündet werden.

Nachteilig ist bei allen genannten Anordnungen, daß der Gesamtwirkungsgrad sehr niedrig ist (zwischen 20 - 40%). Die Ursache dafür ist die im Kondensator gespeicherte Restenergie.

WO 89/06 708 beschreibt eine Schaltungsanordnung zur Stromversorgung für gepulst betriebene Vakuumbögen, mit einer Bogenanode und einer Bogenkathode, die die Entladungsstrecke bilden, einem Kondensator, der die zur Entladung nötige Energie speichert, und einer Diode, wobei parallel zur Entladungsstrecke die Diode derart angeordnet ist, daß die Kathode der Diode mit der Bogenanode und die Anode der Diode direkt mit der Bogenkathode verbunden ist.

DE-A-34 27 520 beschreibt eine Schaltungsanordnung zur Stromversorgung für gepulst betriebene Vakuumbögen mit einer Bogenanode und einer Bogenkatode, die die Entladungsstrecke bilden, und einer Diode, wobei parallel zur Entladungsstrecke (Strecke 5 zwischen Klemme 6 und 7 auf der Verbraucherseite) die Diode derart angeordnet ist, daß die Katode der Diode mit der Bogenanode über die Drosselspule 4 und die Klemme 6 verbunden ist und die Anode der Diode mit der Bogenkatode unmittelbar über die Klemme 7 verbunden ist.

Das Ziel der Erfindung besteht darin, eine Schaltungsanordnung zur Stromversorgung gepulst betriebener Vakuumbögen vorzuschlagen, durch die gegenüber herkömmlichen Anordnungen eine Verbesserung des energetischen Gesamtwirkungsgrades erreicht wird.

Dieses Ziel wird wie im Patentanspruch vorgeschlagen erreicht.

Erfindungsgemäß ist bei der Schaltungsanordnung zur Stromversorgung für gepulst betriebene Vakuumbögen parallel zur Entladungsstrecke eine Diode angeordnet, derart, daß die Katode der Diode mit der Bogenanode und die Diode mit der Bogenkatode verbunden ist.

Mit der erfindungsgemäßen Schaltungsanordnung wird erreicht, daß die während einer Entladung nicht dissipierte Energie zur nächsten Entladung wieder zur Verfügung steht und nur eine geringe Energie zum Nachladen des Kondensators benötigt wird und somit der Gesamtwirkungsgrad steigt.

Ein weiterer Vorteil der erfindungsgemäßen Schaltungsanordnung besteht darin, daß durch den geringeren Energiebedarf beim Ladevorgang eine höhere Pulsfolge möglich wird.

Anhand eines **Ausführungsbeispiels** soll die erfindungsgemäße Schaltungsanordnung näher erläutert werden.

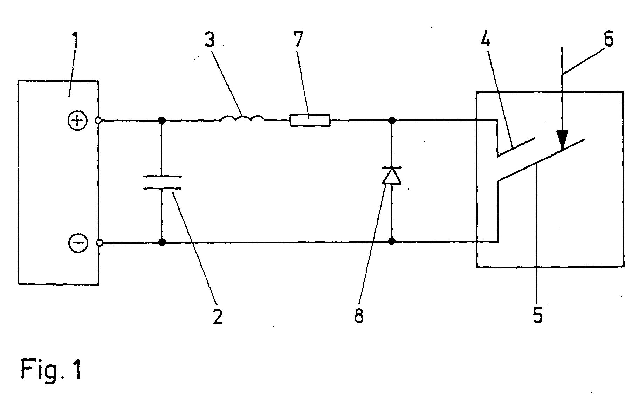

Fig. 1 zeigt einen Vakuumbogenverdampfer üblicher Bauform. Die Zündung erfolgt durch einen hochfokussierten intensiven Laserimpuls (6) kurzer Dauer. Die Stromversorgung erfolgt aus einer leistungsstarken Gleichspannungsquelle (1) (mit einstellbarer Stromergiebigkeit und entkoppeltem Ausgang) üblicher Bauart (u = 400 V, l <100 A), welche einen Kondensator (2) auflädt. Dieser Kondensator (2) hat eine Kapazität von 50 µF und ist über ein Spule (3) von 10 µH direkt mit Anode (4) und Katode (5) der Bogenentladung verbunden. Nach Auftreffen des Laserimpulses (6) (Dauer t = 100 ns, Energie 10 mJ, Leistungsdichte >100 MW/cm²) zündet die Bogenentladung. Wegen des geringen Widerstandes der elektrischen Zuleitungen (in der Fig. 1 symbolisiert durch den Widerstand (7)) hat der vom Kondensator (2), der Spule (3) und dem Leitungswiderstand (7) gebildete Schwingkreis eine hohe Güte und der zeitliche Verlauf von Entladungsstrom und den Spannungsabfällen entspricht nahezu dem eines ungedämpften Schwingkreises. Lediglich der geringe Spannungsabfall über der Bogenentladung führt zu gewissen Abweichungen. Kurz bevor der Entladungsstrom Null wird, erlischt die Vakuumbogenentladung. Die erfindungsgemäß parallel zur Entladungsstrecke geschaltete Diode (8) führt dazu, daß der Strom weiterfließen kann. Der Entladungsverlauf entspricht dabei in erster Näherung der zweiten Halbwelle einer Sinusschwingung. Es hat sich gezeigt, daß auf diese Art und Weise fast die gesamte Energie, die ursprünglich im Kondensator (2) gespeichert war (vermindert um jenen Teil, der in der Bogenentladung umgesetzt wurde) wieder zurückgewonnen werden kann. Von der Stromquelle (1) muß nur der Teil nachgeliefert werden, der wirklich nutzbar geworden ist. Kurzzeitige Spitzen der Brennspannung haben auf die Energiebilanz nur einen geringen Anteil, entsprechend ihrer Dauer. Weiterhin wurde festegestellt, daß nach dem Einbau der Diode (8) Wiederentzündungen nach Polaritätsumkehr, die zu schwerwiegenden Störungen im Entladungsablauf führen können, nicht mehr auftraten.

### Aufstellung der verwendeten Bezugszeichen und Begriffe

- 1): Gleichspannungsquelle
- 2): Kondensator
- 3): Spule
- 4): Anode der Bogenentladung
- 5): Katode der Bogenentladung
- 6): Laserimpuls
- 7): Widerstand
- 8): Diode

## Patentansprüche

1. Schaltungsanordnung zur Stromversorgung für gepulst betriebene Vakuumbögen, mit einer Bogenanode und einer Bogenkathode, die die Entladungsstrecke bilden, einem Kondensator (2), der die zur Entladung nötige Energie speichert, und einer Diode (8), **dadurch gekennzeichnet,** daß parallel zur Entladungsstrecke die Diode (8) derart angeordnet ist, daß die Kathode der Diode (8) direkt mit der Bogenanode (4) und die Anode der Diode (8) direkt mit der Bogenkathode (5) verbunden ist, so daß die nicht dissipierte Energie dem Kondensator (2) zur nächsten Entladung wieder zur Verfügung steht.

## Claims

1. Circuit arrangement for the power supply for pulse-operated vacuum arcs, with an arc anode and an arc cathode, which form the discharge path, a capacitor (2) which stores the energy needed for the discharge, and a diode (8), characterized in that the diode (8) is so arranged parallel to the discharge path that the cathode of the diode (8) is connected directly to the arc anode (4) and the anode of the diode (8) is connected directly to the arc cathode (5), so that the energy which is not dissipated is available to the capacitor (2) again for the next discharge.

## Revendications

1. Circuit d'alimentation en courant pour des arcs sous vide en régime pulsé, comprenant une anode d'arc et une cathode d'arc, qui forment le trajet de décharge, un condensateur (2), qui stocke l'énergie nécessaire à la décharge, et une diode (8),
caractérisé en ce que
en parallèle au trajet de décharge on dispose la diode (8) d'une manière telle que la cathode de la diode (8) est reliée directement à l'anode (4) de l'arc et l'anode de la diode (8) est reliée directement à la cathode de l'arc (5), de telle sorte que l'énergie qui n'est pas dissipée soit à nouveau à la disposition du condensateur (2) pour la décharge suivante.
